# FASCICULE DE BREVET EUROPEEN

(11) **EP 3 075 024 B1**
(45) Date de publication et mention de la délivrance du brevet: **26.12.2018**
(21) Numéro de dépôt: 14814969.3
(22) Date de dépôt: 27.11.2014
(51) Int. Cl.: H01M 10/46, H01G 9/20, H01L 23/58, H01L 31/0224, H01L 31/0264, H01L 31/0392, H01L 31/04, H01L 31/053, H01M 14/00, H01M 4/485, H01M 4/58, H02S 40/38, H01M 4/52, H01M 4/505, H01M 4/50, H01M 4/48, H01M 10/0525

(54) **DISPOSITIF ÉLECTROCHIMIQUE AUTOPHOTORECHARGEABLE TRANSPARENT**
TRANSPARENTE, DURCH LICHT SELBSTAUFLADBARE ELEKTROCHEMISCHE VORRICHTUNG
TRANSPARENT SELF-PHOTORECHARGEABLE ELECTROCHEMICAL DEVICE

(30) Priorité: 28.11.2013 FR 1361775
(43) Date de publication de la demande: 05.10.2016
(73) Titulaire: Centre National de la Recherche Scientifique, 75016 Paris (FR); Université de Picardie Jules Verne, 80025 Amiens Cedex 1 (FR); Sorbonne Université, 75006 Paris (FR)
(72) Inventeur: SAUVAGE, Frédéric, F-80290 Digeon (FR); ANDRIAMIADAMANANA, Christian, F-80136 Rivery (FR); LABERTY, Christel, F-75005 Paris (FR)
(74) Mandataire: LLR
(86) Numéro de dépôt international: PCT/FR2014/053056
(87) Numéro de publication internationale: WO 2015/079170

(56) Documents cités:
- EP-A1- 2 453 516
- US-A- 4 916 035
- US-A1- 2008 210 296
- US-A1- 2009 078 307
- US-A1- 2009 146 604
- SHARON M ET AL: "Solar rechargeable battery-principle and materials", ELECTROCHIMICA ACTA, ELSEVIER SCIENCE PUBLISHERS, BARKING, GB, vol. 36, no. 7, 1 janvier 1991 (1991-01-01), pages 1107-1126, XP026527620, ISSN: 0013-4686, DOI: 10.1016/0013-4686(91)85097-Q [extrait le 1991-01-01]

## Description

La présente invention concerne un dispositif électrochimique photorechargeable transparent, l'utilisation d'un semi-conducteur de type n en tant que matière active d'électrode positive pour ledit dispositif électrochimique photorechargeable transparent, et un procédé de photorecharge dudit dispositif. En particulier, elle se rapporte au domaine des batteries alcalines, et notamment des batteries au lithium.

Les batteries au lithium sont devenues des constituants indispensables dans de nombreux dispositifs qui comprennent des appareils portables, tels que notamment les téléphones mobiles, les ordinateurs et l'outillage léger, ou des appareils plus lourds tels que des moyens de transports à deux roues (bicyclettes, cyclomoteurs) ou à quatre roues (véhicules automobiles électriques ou hybrides). Elles sont également largement étudiées pour une utilisation dans le domaine du stockage d'énergie.

Une batterie au lithium comprend au moins une électrode négative et au moins une électrode positive entre lesquelles est placé un électrolyte solide ou un séparateur imprégné par un électrolyte liquide. L'électrolyte liquide est par exemple constitué d'un sel de lithium en solution dans un solvant choisi pour optimiser le transport et la dissociation des ions. L'électrode positive est constituée par un collecteur de courant supportant un matériau d'électrode qui contient au moins une matière active d'électrode positive capable d'insérer des ions lithium de manière réversible ; l'électrode négative est constituée par une feuille de lithium métallique (éventuellement supportée par un collecteur de courant), d'un alliage de lithium ou d'un composé intermétallique de lithium (batterie au lithium), ou par un collecteur de courant supportant un matériau d'électrode qui contient au moins une matière active d'électrode négative capable d'insérer des ions lithium de manière réversible (batterie aux ions lithium).

Au cours du fonctionnement de la batterie, des ions lithium passent de l'une à l'autre des électrodes à travers l'électrolyte. Lors de la décharge de la batterie, une quantité de lithium réagit avec la matière active d'électrode positive à partir de l'électrolyte, et une quantité équivalente est introduite dans l'électrolyte à partir de la matière active de l'électrode négative, la concentration en lithium restant ainsi constante dans l'électrolyte. L'insertion du lithium dans l'électrode positive est compensée par apport d'électrons à partir de l'électrode négative *via* un circuit extérieur. Lors de la charge, les phénomènes inverses ont lieu.

Les densités massiques d'énergie obtenues actuellement dans les différents systèmes de stockage électrochimique de l'énergie sont de 200-250 Wh/kg pour les meilleures batteries Li-ion, de 100-150 Wh/kg pour une batterie Na-ion, de 350 Wh/kg pour une batterie Li-S, 500 Wh/kg pour une batterie lithium-air et de 50 Wh/kg pour une batterie à flux rédox (bien connue sous l'anglicisme "*redox-flow battery*")*.* Ces batteries présentent donc des densités massiques d'énergie relativement faibles et doivent être rechargées *via* le réseau électrique, induisant des quantités limitées d'énergie délivrable.

Par ailleurs, au cours de la dernière décennie, des dispositifs permettant de transformer l'énergie solaire en énergie électrique ont été proposés. En particulier, Grätzel a développé une cellule photovoltaïque à pigment photosensible (bien connue sous l'anglicisme *dye-sensitized solar cell, DSSc, DSC,* ou *DYSC*) comprenant une couche transparente conductrice d'électricité d'oxyde d'étain dopé au fluor SnO₂•F, sur laquelle est placée une photoanode d'oxyde de titane TiO₂ à la surface de laquelle un pigment photosensible (e.g. complexe polypyridilé de ruthénium (+II)) a été greffé, une contre-électrode de platine et un électrolyte iodure/triiodure (I⁻/I₃⁻). Cependant, une telle cellule photovoltaïque ne permet pas le stockage de l'énergie.

D'autres systèmes tels que des photocondensateurs combinant deux technologies, c'est-à-dire une cellule photovoltaïque et un condensateur, ont été développés afin de permettre le stockage de l'électricité directement convertie à partir de l'énergie lumineuse. De façon générale, de tels systèmes comprennent une photoélectrode, une électrode interne bifonctionnelle, c'est-à-dire qui fonctionne à la fois comme cathode et comme anode, et qui se trouve à la jonction avec deux électrolytes différents, et une contre-électrode dans la partie condensateur. Cependant, afin de maintenir de bonnes performances, la migration et/ou la diffusion des espèces oxydoréductrices vers la partie condensateur doit être inhibée, induisant des difficultés dans la fabrication de tels systèmes et dans la conception de matériaux performants. Par ailleurs, de tels systèmes présentent un coût de production élevé. A titre d'exemple, US2009/0078307 décrit un dispositif couplant deux technologies : une cellule photovoltaïque de type DSSc et une batterie anionique. Toutefois, les capacités de stockage atteintes sont relativement faibles puisqu'elles sont de l'ordre de 0,01 mAh/cm².

Tributsch [J. Appl. Phys., 1987, 62, 11, 4597-4605] a donc proposé des batteries photorechargeables utilisant des semiconducteurs capables de photoinduire de manière réversible l'intercalation d'ions métalliques. En particulier, Tributsch propose une batterie photorechargeable comprenant une photoélectrode comprenant un semiconducteur de type p tel que le thiosulfate de cuivre Cu₃PS₄, une contre-électrode tel qu'un fil de cuivre, et un électrolyte comprenant une solution de chlorure de cuivre (CuCI) et de tétrabutylammoniumperchlorate (TBAPC) dans de l'acétonitrile. Cependant, les performances obtenues sont limitées, notamment de par la cinétique lente de la réaction de décharge. Par ailleurs, l'utilisation du cuivre ne permet pas d'atteindre des tensions élevées. Enfin, les semiconducteurs à base de soufre sont à éviter puisqu'ils induisent généralement au cours de l'excitation par des ondes lumineuses, la photoélectrolyse de l'eau même si l'électrolyte n'en contient que de faibles quantités. En outre, de tels semiconducteurs peuvent corroder dans l'électrolyte.

US4916035 décrit une cellule photoélectrochimique qui présente à la fois les fonctions de cellules solaire et secondaire.

US2009/0146604 décrit un dispositif photorechargeable comprenant une cellule photovoltaique à pigment photosensible et une batterie au lithium secondaire qui ont en commun une anode.

Ainsi, aucun des documents de l'art antérieur ne décrit un système permettant à la fois la conversion de l'énergie lumineuse en énergie électrique et son stockage sous forme d'énergie chimique, et présentant de bonnes capacités de stockage, de manière à rendre ledit système autonome vis-à-vis du réseau électrique, notamment grâce à sa recharge sous l'effet d'ondes lumineuses.

Le but de la présente invention est de fournir un dispositif électrochimique photorechargeable transparent qui puisse à la fois stocker de l'énergie et être rechargé sous l'effet d'ondes lumineuses, notamment en mettant en oeuvre une seule technologie. En particulier, la présente invention a pour but de pallier tout ou en partie les inconvénients précités et de fournir un dispositif électrochimique photorechargeable transparent qui se recharge sous l'effet d'ondes lumineuses en quelques minutes quel que soit son niveau de décharge, qui présente une densité d'énergie et une puissance significativement augmentées par rapport à celles des dispositifs proposés dans l'art antérieur, et enfin qui résolve le problème des cycles intermittents de la lumière.

La présente invention a donc pour premier objet un dispositif électrochimique photorechargeable transparent, ledit dispositif étant caractérisé en ce qu'il comprend :
- une électrode positive comprenant un support transparent conducteur sur lequel est déposé un film d'électrode positive, ledit film d'électrode positive comprenant un semi-conducteur de type n à titre de matière active d'électrode positive, ledit semiconducteur de type n présentant une largeur de bande interdite Eg et étant capable d'intercaler et de dés-intercaler des ions d'un métal alcalin M1 ;
- une électrode négative comprenant un élément choisi parmi ledit métal alcalin M1, un alliage dudit métal alcalin M1, et un composé intermétallique dudit métal alcalin M1 ; et
- un électrolyte liquide non aqueux comprenant un sel dudit métal alcalin M1 et un solvant organique ;
- lesdites électrodes positive et négative ayant respectivement des potentiels d'électrode E1 et E2, avec E1 > E2, E1 et E2 étant calculés par rapport au potentiel d'électrode du couple M1⁺/M1⁰.

Dans la présente invention, l'expression « dispositif (ou support) transparent » signifie un dispositif (ou un support) qui laisse passer les ondes lumineuses (i.e. lumière).

Les ondes lumineuses peuvent comprendre les ondes électromagnétiques dont la longueur d'onde correspond au spectre visible, soit entre les longueurs d'onde 380 et 780 nm, les ondes électromagnétiques situées dans les domaines du proche infrarouge, soit entre les longueurs d'onde 780 et 3000 nm, et les ondes électromagnétiques situées dans une partie des domaines de l'ultra-violet, c'est-à-dire entre les longueurs d'ondes 310 et 380 nm.

Les ondes électromagnétiques dont la longueur d'onde correspond au spectre visible, soit entre les longueurs d'onde 380 et 780 nm, sont particulièrement préférées.

On entend par support « conducteur », un support qui a une conductivité allant de 10⁻¹ S/cm à 10³ S/cm environ.

Le dispositif électrochimique photorechargeable transparent conforme à l'invention fonctionne sous l'effet d'ondes lumineuses provenant de tout type de sources, c'est-à-dire aussi bien d'une source naturelle (soleil) que d'une source artificielle (lampes). De plus, il est capable de se recharger sous l'effet d'ondes lumineuses en quelques minutes quel que soit son niveau de décharge, de se recharger occasionnellement dans l'obscurité lorsqu'il a été exposé pendant un certain temps à une source d'ondes lumineuses, et il présente de très bonnes performances électrochimiques, notamment grâce au processus de photorecharge suffisamment rapide qui compense sa décharge si celle-ci se produit sous illumination.

En outre, ledit dispositif permet d'intégrer des éléments électriques plus ou moins énergivores dans des zones géographiques dépourvues de réseau d'alimentation électrique générale et de réduire le coût de production et de stockage du kWh solaire. Enfin, le dispositif de l'invention met en oeuvre une seule technologie et permet ainsi d'éviter l'utilisation de systèmes complexes couplant deux technologies telles que celles décrites dans l'art antérieur.

Selon un mode de réalisation particulier de l'invention, le dispositif de l'invention est constitué de l'électrode positive, de l'électrode négative et de l'électrolyte liquide non aqueux telles que définies dans la présente invention.

Dans un mode de réalisation préféré, les potentiels d'électrode E1 et E2 sont compris entre 0 et 5 Volts par rapport au couple M1⁺/M1⁰.

Dans un mode de réalisation particulier, le dispositif conforme à l'invention est hermétique.

Dans un mode de réalisation particulier, le métal alcalin M1 du dispositif conforme à l'invention est choisi parmi le lithium, le sodium et le potassium. Le lithium est préféré.

Dans un mode de réalisation particulier, le semi-conducteur de type n du dispositif électrochimique photorechargeable transparent conforme à l'invention est choisi parmi les oxydes de métaux, les phosphates de métaux, les sulfates de métaux, et les oxalates de métaux, dans lesquels lesdits métaux sont choisis parmi Sc, Ti, V, Cr, Mn, Fe, Co, Ni, Cu, Zn, Y, Zr, Nb, Mo, Tc, Ru, Rh, Pd, Ag, Cd, Hf, Ta, W, Re, Os, Ir, Pt, Au, Hg, Rf, Db, Sg, Bh, Hs, Mt, Ds, Rg, Cn (i.e. métaux de transition) et Bi.

Les métaux sont choisis de préférence parmi Ti, Fe, Mn, Co, Ni, Sn, Ru, Bi, V, Cr, Cu, Nb, Mo et Zn.

A titre d'exemple d'oxydes de métaux, on peut notamment citer TiO₂, Fe₂O₃, Fe₃O₄, MnO₂, CoO, Co₃O₄, NiO, SnO₂, RuO₂, Bi₂O₃, VO₂, V₂O₅, Cr₂O₃, CuO, Cu₂O, Nb₂O₅, MoO₃, ZnO.

Les oxydes de métaux préférés sont choisis parmi TiO₂, Fe₂O₃, Fe₃O₄, MnO₂, CoO, Co₃O₄, SnO₂, RuO₂, Bi₂O₃, VO₂, V₂O₅, Cr₂O₃, Nb₂O₅ et ZnO.

Le semi-conducteur de type n est de préférence TiO₂.

A titre d'exemple de phosphates de métaux, on peut notamment citer :
- les olivines répondant à la formule MM'PO₄, dans laquelle M = Li ou Na et M' = Fe, Co, Mn, Ni ou un de leurs mélanges,
- les dérivés fluorés, hydroxylés et oxygénés répondant aux formules MₓM"PO₄F, MₓM"PO₄.OH et MₓM"PO₄.O, dans lesquelles M a la même définition que ci-dessus, M" = Fe, Co, Mn, Ni, V ou Ti et x va de 0 à 2,
- les carbonophosphates répondant à la formule M₃M'PO₄CO₃, dans laquelle M et M' ont les mêmes définitions que ci-dessus, et enfin
- les pyrophosphates répondant à la formule MₓM'P₂O₇, dans laquelle M, M' et x ont les mêmes définitions que ci-dessus.

A titre d'exemple de sulfates de métaux, on peut notamment citer les matériaux répondant aux formules M'₂(SO₄)₃, MM"SO₄F et MₓM"OSO₄, dans lesquelles M, M', M" et x ont les mêmes définitions que ci-dessus.

A titre d'exemple d'oxalates de métaux, on peut notamment citer les composés répondant à la formule M₂M'(C₂O₄)₂, dans laquelle M et M' ont les mêmes définitions que ci-dessus.

Le semi-conducteur de type n convenant pour la présente invention est de préférence de l'oxyde de titane (TiO₂), et de manière encore plus préférée de l'oxyde de titane anatase (TiO₂ anatase).

Dans la présente invention, les potentiels d'électrode E1 et E2 sont mesurés par rapport au potentiel d'électrode de M1⁺/M1⁰, et l'on a E1 > E2. Dans le cas où l'on considèrerait les potentiels d'énergie électronique E1' et E2' respectivement des électrodes positive et négative du dispositif de la présente invention, on aurait la relation inverse E1' < E2' puisque E1' et E2' seraient mesurées par rapport au zéro de l'échelle des énergies électroniques, c'est-à-dire par rapport à l'énergie de l'électron dans le vide.

Lorsque la valeur de E1 se rapproche de la valeur de E2 tout en respectant E1 > E2, le dispositif électrochimique photorechargeable transparent conforme à l'invention accumule de l'énergie chimique au cours de l'absorption de la lumière à travers la réaction de dés-intercalation des ions du métal alcalin M1, qui se produit au cours de l'oxydation du métal (métal de transition ou Bi) présent dans le semi-conducteur de type n. Cette photo-oxydation du semi-conducteur de type n résulte du phénomène de séparation de charge qui a lieu lors de l'absorption de la lumière. Ce phénomène se passe majoritairement dans la zone de déplétion électronique du semi-conducteur de type n où une accumulation importante de trous d'électron à la surface dudit semi-conducteur de type n se produit.

Ainsi, dans le dispositif de l'invention, l'électrode positive représente une photoélectrode. Au cours du fonctionnement du dispositif, l'électrode positive intercale et dés-intercale des ions du métal alcalin M1 grâce à la présence du semiconducteur de type n contenu dans ladite électrode positive. L'électrode négative correspond à une électrode négative d'une batterie au lithium conventionnelle. Au cours du fonctionnement du dispositif, elle intercale et dés-intercale des ions du métal alcalin M1.

Dans le dispositif de l'invention, l'électrode positive ne comprend pas d'autre(s) élément(s) que le semiconducteur de type n pour intercaler et dés-intercaler des ions du métal alcalin M1.

Dans un mode de réalisation particulier, le semi-conducteur de type n a une largeur de bande interdite Eg d'au plus 4,0 eV environ, et de préférence de 0,4 eV à 3,5 eV environ et de manière encore plus préférée de 1,2 eV à 3,5 eV.

Les semiconducteurs de type n de l'invention ont une largeur de bande interdite compatible avec la gamme de tension maximale [4,5-5 volts] à laquelle l'électrolyte du dispositif est stable. Ainsi, les semiconducteurs de type n de l'invention sont stables à l'état oxydé et réduit, et évitent toute réaction oxydante de dégradation de l'électrolyte.

En d'autres termes, le dispositif de l'invention ne requiert pas de système de protection telle qu'une diode Zener.

Dans un mode de réalisation particulier, ledit film d'électrode positive comprenant ledit semi-conducteur de type n à titre de matière active d'électrode positive présente une épaisseur allant de 0,1 à 25 µm environ, et de préférence de 0,5 à 15 µm environ.

Dans un mode de réalisation particulier, le semi-conducteur de type n est sous forme de nanoparticules, c'est-à-dire qu'il peut comprendre des particules de diamètre allant de 2 à 50 nm environ, de préférence de diamètre allant de 2 à 20 nm environ, et de manière encore plus préférée de diamètre allant de 2 à 10 nm environ. Lorsque les particules du semi-conducteur de type n ont un diamètre inférieur à 2 nm, l'électrolyte ne peut pas facilement pénétrer dans ledit film d'électrode positive et ainsi l'imprégner efficacement. Lorsque les particules du semi-conducteur de type n ont un diamètre supérieur à 50 nm, l'intercalation des ions du métal alcalin M1 dans le semi-conducteur de type n devient difficile et de ce fait, elle peut devenir incomplète.

Dans un mode de réalisation particulier, le semi-conducteur de type n a une surface spécifique mesurée par la méthode B.E.T. allant de 20 m²/g à 500 m²/g environ, et de préférence de 150 m²/g à 400 m²/g environ, et de manière encore plus préférée de 230 m²/g à 310 m²/g environ.

Grâce au fait qu'il se présente sous forme de nanoparticules et à sa grande surface spécifique, le semi-conducteur de type n présente une grande réactivité de surface. Ainsi, l'insertion et la conduction des ions du métal alcalin M1 dans ledit semi-conducteur de type n sont facilitées.

Dans un mode de réalisation particulier, le film d'électrode positive a une structure poreuse comprenant au moins des mésopores, et de préférence une structure mésoporeuse.

Dans un mode de réalisation particulier, le semi-conducteur de type n représente au moins 90% en masse environ, de préférence au moins 95% en masse environ, et de manière encore plus préférée au moins 98% en masse environ par rapport à la masse totale du film d'électrode positive.

Le sel du métal alcalin M1 utilisé dans l'électrolyte liquide du dispositif conforme à l'invention peut être choisi par exemple parmi les sels de lithium tels que LiPF₆, LiAsF₆, LiClO₄, LiBF₄, LiC₄BO₈, Li(C₂F₅SO₂)₂N, Li[(C₂F₅)₃PF₃], LiCF₃SO₃, LiCH₃SO₃, LiN(SO₂CF₃)₂ et LiN(SO₂F)₂, les sels de sodium tels que NaClO₄, NaBF₄, NaPF₆, Na₂SO₄, NaNO₃, Na₃PO₄, Na₂CO₃, le bis(trifluorométhanesulfonyl)imide de sodium (NaTFSI), le bis(perfluoroalkylsulfonyl) méthane de sodium, le tris(perfluoroalkylsulfonyl)méthane de sodium, et les sels de potassium tels que KPF₆, KAsF₆, KClO₄, KBF₄, KCF₃SO₃, KCH₃SO₃ et KN(SO₂CF₃)₂.

Parmi de tels sels, M1PF₆ (M1 = Li, Na ou K) sont particulièrement préférés.

Le solvant organique utilisé dans l'électrolyte liquide du dispositif conforme à l'invention permet d'optimiser le transport et la dissociation des ions du métal alcalin M1.

Il peut comprendre un ou plusieurs composés polaires aprotiques choisis parmi les carbonates linéaires ou cycliques, les éthers linéaires ou cycliques, les esters linéaires ou cycliques, les sulfones linéaires ou cycliques, les sulfamides et les nitriles. Le solvant organique comprend de préférence, au moins deux carbonates choisis parmi le carbonate d'éthylène, le carbonate de propylène, le carbonate de diméthyle, le carbonate de diéthyle et le carbonate de méthyle et d'éthyle.

Le film d'électrode positive du dispositif conforme à l'invention peut comprendre en outre un agent générant une conductivité électronique, ledit agent générant une conductivité électronique étant choisi de manière à extraire et conduire les électrons tout en n'absorbant pas la lumière ou en absorbant la lumière le moins possible, c'est-à-dire avec une proportion d'absorption inférieure à celle du semi-conducteur de type n. L'agent générant une conductivité électronique convenant pour la présente invention est de préférence choisi parmi le noir de carbone, le carbone SP, le noir d'acétylène, les fibres et nanofibres de carbone, les nanotubes de carbone, les fibres métalliques et semi-métalliques et l'un de leurs mélanges. Lorsqu'il est utilisé, l'agent générant une conductivité électronique représente généralement au plus 15% en masse environ, et de préférence au plus 5% en masse environ, et de manière encore plus préférée au plus 3% par rapport à la masse totale du film d'électrode positive.

De préférence, le film d'électrode positive de l'invention ne comprend pas d'agent générant une conductivité électronique.

Dans un mode de réalisation particulier, le film d'électrode positive du dispositif conforme à l'invention peut comprendre en outre un liant, ledit liant étant choisi de manière à améliorer la cohésion entre les particules de matière active et/ou entre les particules de matière active et d'agent générant une conductivité électronique s'il est présent. Ledit liant ne doit pas absorber la lumière. Le liant convenant pour la présente invention est de préférence choisi parmi les dérivés de la cellulose tels que l'hydroxyéthylcellulose, les polymères fluorés tels que le PVDF et le PVDF-HFP. Lorsque le liant est utilisé, il représente généralement au plus 5% en masse environ, et de préférence au plus 3% en masse environ, par rapport à la masse totale du film d'électrode positive.

De préférence, le film d'électrode positive de l'invention ne comprend pas de liant.

Dans un mode de réalisation particulier, le film d'électrode positive du dispositif conforme à l'invention comprend en outre des additifs tels que des colorants et/ou des réflecteurs de lumière.

De préférence, le film d'électrode positive comprend au moins un colorant et/ou au moins un réflecteur de lumière.

Les colorants permettent d'absorber plus de lumière et ainsi, d'améliorer l'utilisation de la lumière. A titre d'exemple de colorants, on peut notamment citer les complexes polypyridilés de ruthénium (+II), d'osmium (+II), de fer (+II) ou de cuivre (+II), les molécules organiques de type donneur-Π-accepteur, et d'autres molécules organiques telles que les périlènes diimides, les squaraines, les phtalocyanines, les anthocyanes, les indolines, les coumarines, ou l'éosine Y.

Le film d'électrode positive peut comprendre au plus 2% en masse environ, et de préférence au plus 1% en masse environ de colorants.

Les réflecteurs de lumière sont des matériaux ayant un indice de réfraction élevé, de préférence allant de 1,5 à 4. Ils permettent de mieux confiner la lumière dans le semi-conducteur de type n. A titre d'exemple de réflecteurs de lumière, on peut notamment citer les macropores, les cristaux photoniques (e.g. SiO₂/TiO₂), les structures plasmoniques et tous les oxydes semi-conducteurs ou isolants dont la taille des particules est comparable aux longueurs d'onde de la lumière incidente que l'on désire faire réfléchir.

De préférence, les oxydes semi-conducteurs sont choisis parmi TiO₂ anatase, TiO₂ rutile, SiO₂, ZrO₂, Nb₂O₅ et les composés de la famille des pérovskites suivants : SrTiO₃, CaTiO₃ et BaTiO₃.

A titre d'exemple, le film d'électrode positive du dispositif conforme à l'invention peut comprendre des particules de TiO₂ anatase de diamètre allant de 4 à 6 nm en tant que semi-conducteur de type n, et des particules de TiO₂ anatase de diamètre allant de 400 à 800 nm en tant que réflecteur de lumière. Les particules de TiO₂ anatase de diamètre allant de 400 à 800 nm réfléchissent la lumière qui n'a pas été absorbée par le semi-conducteur de type n.

De préférence, le réflecteur de lumière est différent du semi-conducteur de type n.

Le film d'électrode positive peut comprendre au plus 15% en masse environ, et de préférence au plus 5% en masse environ de réflecteurs de lumière.

Dans un mode de réalisation particulier, le support transparent conducteur est un verre transparent conducteur de type FTO (oxyde d'étain dopé au fluor), de type ITO (oxyde d'étain dopé à l'indium), ou de type ZITO (oxyde d'étain dopé à l'indium et au zinc).

Dans un autre mode de réalisation, le support transparent conducteur est un support souple conducteur de type PET (polyéthylène téréphtalate) ou PEN (polyéthylène naphtalate).

Dans un mode de réalisation particulier, ledit support transparent conducteur présente une épaisseur allant de 100 à 4000 µm environ, et de préférence de 500 à 3000 µm environ.

Dans un mode de réalisation particulier, le dispositif conforme à l'invention est relié à un appareil de mesure de potentiel et de courant, afin d'évaluer et de suivre l'état de charge dudit dispositif.

Les techniques permettant d'obtenir le film d'électrode positive avec une structure mésoporeuse sont bien connues de l'homme du métier. A titre d'exemple, le semi-conducteur de type n est mélangé avec un solvant organique (e.g. terpinéol) et un composé organique (e.g. dérivé de la cellulose) pour former une pâte. Puis, la pâte est calcinée afin de décomposer le composé organique tout en évaporant le solvant. A l'issue de la calcination, le composé organique n'est plus présent au sein du film d'électrode positive de l'invention.

Un dérivé de la cellulose peut être l'hydroxyéthylcellulose, la méthylcellulose, l'hydroxypropylméthylcellulose ou la carboxyméthylcellulose.

Les techniques permettant de déposer le film d'électrode positive comprenant le semi-conducteur de type n sur ledit support transparent conducteur dans le dispositif conforme à l'invention sont des techniques bien connues de l'homme du métier. Elles peuvent comprendre l'impression par sérigraphie (bien connue sous l'anglicisme « *screen-printing* »), l'ablation laser pulsée ou la technique sol-gel associée au trempage-retrait (bien connue sous l'anglicisme « *dip-coating* »)*.*

La présente invention a pour deuxième objet l'utilisation d'un semi-conducteur de type n en tant de matière active d'électrode positive pour le dispositif électrochimique photorechargeable transparent conforme à l'invention tel que défini ci-dessus.

Ledit semi-conducteur de type n utilisé en tant que matière active d'électrode positive dans le dispositif électrochimique photorechargeable transparent conforme à l'invention peut être ledit semi-conducteur de type n tel que décrit précédemment.

La présente invention a pour troisième objet un procédé de photorecharge du dispositif électrochimique photorechargeable transparent conforme à la présente invention, ledit procédé étant caractérisé en ce qu'il comprend l'étape suivante :
i) l'exposition dudit dispositif, de préférence du côté dudit dispositif comprenant ladite électrode positive, à une source d'ondes lumineuses pendant au moins 30 minutes, et de préférence pendant au moins 1 heure, pour obtenir ledit dispositif rechargé.

Dans ledit procédé, le dispositif avant l'étape i) est soit complètement déchargé, soit au moins en partie déchargé, la décharge s'étant produite par utilisation dudit dispositif comme « batterie » pour alimenter un appareil électrique, tel qu'un téléphone portable, un ordinateur, etc....

Lorsque le dispositif avant l'étape i) est complètement déchargé, il ne peut pas être utilisé avant l'étape i) comme « batterie » pour alimenter un appareil électrique pendant l'étape i).

En revanche, pendant l'étape i), le dispositif peut être utilisé comme « batterie » pour alimenter un appareil électrique concomitamment avec l'étape i), à condition que le dispositif consomme moins d'énergie que celle produite pendant ladite étape i), c'est-à-dire pendant l'absorption d'ondes lumineuses.

Dans un mode de réalisation particulier, l'étape i) peut être effectuée autant de fois que nécessaire, notamment lorsque l'utilisateur dudit dispositif dispose toujours d'une source d'ondes lumineuses pour recharger ledit dispositif.

Dans ce procédé, aucun apport d'électricité n'est nécessaire pour recharger ledit dispositif.

Le procédé de photorecharge de l'invention ne requiert pas la présence d'un booster de tension au sein dudit dispositif pour permettre la photorecharge au cours de l'étape i), comme cela peut être le cas dans les systèmes complexes de l'art antérieur combinant deux technologies.

Dans un mode de réalisation particulier, la source d'ondes lumineuses est une lampe blanche.

Dans un mode de réalisation encore plus particulier, la source d'ondes lumineuses a une intensité allant de 1 à 3000 mW/cm², et de préférence de 10 à 300 mW/cm².

Le procédé de photorecharge de l'invention fonctionne toutefois indépendamment de l'intensité lumineuse. En d'autres termes, même une intensité faible (i.e. de l'ordre de 10 mW/cm²) va permettre la photorecharge du dispositif même si cela prendra un peu plus de temps que si une intensité supérieure était utilisée.

Enfin, le procédé de photorecharge de l'invention n'induit pas d'autodécharge.

La présente invention a également pour objet un procédé de recharge dans le noir du dispositif électrochimique photorechargeable transparent conforme à la présente invention, ledit procédé étant caractérisé en ce qu'il comprend les étapes suivantes :
i') l'exposition dudit dispositif, de préférence du côté dudit dispositif comprenant ladite électrode positive, à une source d'ondes lumineuses pendant au moins 10 heures, et de préférence pendant au moins 12 heures,
ii') l'utilisation du dispositif de l'étape i') pour alimenter un appareil électrique, et
iii') la relaxation dans le noir du dispositif de l'étape ii') pendant au moins 6 heures, et de préférence pendant au moins 12 heures, pour obtenir ledit dispositif rechargé.

Avant l'étape i'), le dispositif est de préférence complètement chargé.

Après l'étape ii'), le dispositif est de préférence complètement déchargé.

Dans un mode de réalisation particulier, les étapes ii') et iii') peuvent être successivement réitérées une ou plusieurs fois, de préférence une fois.

Ce procédé peut s'appliquer lorsque l'utilisateur dudit dispositif dispose initialement d'une source d'ondes lumineuses, puis n'a plus accès pendant quelques jours à aucune source d'ondes lumineuses.

### EXEMPLE DE PREPARATION D'UN DISPOSITIF ELECTROCHIMIOUE PHOTORECHARGEABLE TRANSPARENT

### 1.1 Préparation de TiO₂ anatase « comme semi-conducteur de type n »

30 ml d'isopropoxyde de titane (Ti(OiPr)₄) ont été ajoutés à 300 ml d'eau puis la solution résultante a été agitée vigoureusement pendant 4 heures environ jusqu'à l'hydrolyse complète. Le précipité blanc obtenu a ensuite été filtré sous vide ou centrifugé, lavé plusieurs fois avec de l'eau puis de l'éthanol, et séché à température ambiante.

Ledit précipité séché a ensuite été placé en présence d'une solution aqueuse à 0,1 mole/litre de NH₄F pendant 7 jours à 60°C.

Des nanoparticules de TiO₂ de diamètre allant de 4 à 6 nm environ et de surface spécifique de 235-300 m²/g environ (méthode B.E.T.).

### 1.2 Préparation de l'électrode positive comprenant un support conducteur transparent sur lequel est déposé un film d'électrode positive comprenant le TiO₂ anatase tel qu'obtenu ci-dessus

L'électrode positive a été obtenue en déposant par sérigraphie sur un support conducteur transparent FTO une pâte imprimable comprenant 12g du TiO₂ anatase tel que préparé ci-dessus à l'étape 1.1, 7,2g d'hydroxyéthylcellulose et 65g de terpinéol. La pâte comprend généralement 22% en masse d'hydroxyéthylcellulose de viscosité allant de 30 à 50 mPas, et 38% en masse d'hydroxyéthylcellulose de viscosité allant de 5 à 15 mPas pour 65g de terpinéol et quelle que soit la quantité initiale de TiO₂ dans ladite pâte.

Après séchage de la pâte imprimable sur le support et calcination, une électrode positive comprenant un support conducteur transparent sur lequel est déposé un film d'électrode positive comprenant uniquement du TiO₂ a été obtenue.

L'impression par sérigraphie a été effectuée avec un appareil de sérigraphie vendu sous la dénomination commerciale Precima par la société TIFLEX.

L'aire surfacique de ladite électrode positive a été déterminée à partir de la taille de l'écran sérigraphique.

L'épaisseur de ladite électrode positive (film) a été mesurée à l'aide d'un appareil vendu sous la dénomination commerciale DEKTAK III par la société Veeco.

La porosité de ladite électrode positive a été calculée à partir du rapport entre la masse réelle de l'électrode et la masse théorique déterminée à partir de ses dimensions.

Le film d'électrode positive obtenue présentait une aire surfacique de 0,16 cm², une épaisseur de 12 µm et une porosité de 50% environ.

### 1.3 Assemblage du dispositif électrochimique photorechargeable

Le dispositif conforme à l'invention a été obtenu en disposant dans une boîte à gant remplie d'argon une cellule photo-électrochimique en verre blanc transparent comprenant :
- l'électrode telle que préparée ci-dessus à l'étape 1.2 en tant qu'électrode positive,
- une feuille de lithium en tant qu'électrode négative et électrode de référence, et
- une solution à 1 mol/L de sel de lithium LiPF₆ dans un solvant organique carbonate d'éthylène/carbonate de diméthyle (1/1 en masse) en tant qu'électrolyte liquide.

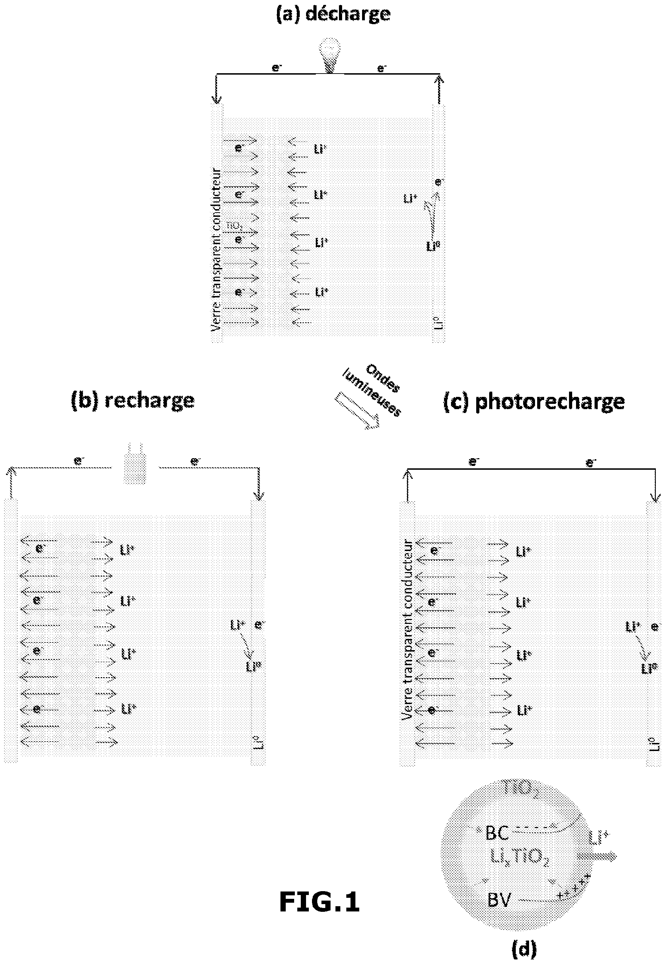

La figure 1 annexée montre le principe de fonctionnement du dispositif selon l'invention. Durant la décharge (figure la), le principe de fonctionnement du dispositif est analogue à celui d'une batterie classique, c'est-à-dire qu'il se produit une insertion d'électrons et d'ions lithium à l'électrode positive permettant sa réduction accompagnée par une réaction d'oxydation du lithium métal en ions lithium à l'électrode négative. Dans un dispositif classique, cette réaction peut être inversée, c'est-à-dire que durant la recharge, il se produit l'oxydation de l'électrode positive induisant une libération d'électrons et d'ions lithium s'accompagnant par une réaction de réduction à l'électrode négative des ions lithium en lithium métal (figure 1b). Cette réaction permet la recharge de la batterie par le biais d'un apport externe d'électricité (eg. réseau électrique de distribution).

Cette recharge peut toutefois être obtenue en substituant la connexion de la batterie au réseau électrique externe grâce à l'illumination de l'électrode photo-active qui va induire une séparation des paires électrons/trous dans la zone de déplétion du semi-conducteur de type n (figures 1c et 1d). BV et BC représentent respectivement les bandes de valence et de conduction. Les porteurs de charge minoritaire vont alors migrer vers la surface des particules de semi-conducteur de type n (i.e. TiO₂) conduisant à l'oxydation du Ti³⁺ en Ti⁴⁺, et par compensation des charges extraire le lithium contenu dans lesdites particules. Les électrons sont transportés et collectés pour conduire à la réaction de réduction à l'électron négative et ainsi réaliser la réaction photo-électrochimique.

### 1.4 Etude du comportement du dispositif conforme à l'invention en circuit fermé dans le noir et en présence d'une source d'ondes lumineuses

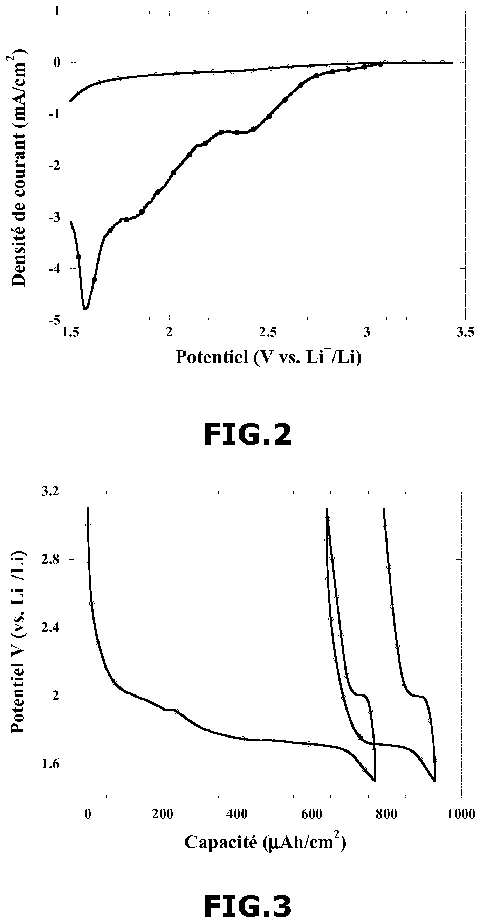

La figure 2 annexée montre la densité de courant du dispositif électrochimique de l'invention tel qu'obtenu ci-dessus (en mA/cm²) en fonction du potentiel par rapport au couple Li⁺/Li (en volts, V). La courbe avec les ronds vides illustre le comportement du dispositif électrochimique de l'invention pendant la décharge en l'absence d'illumination (dans le noir), alors que la courbe avec les ronds pleins illustre le comportement du dispositif électrochimique de l'invention pendant la décharge lorsque l'électrode positive (TiO₂) est soumise à une source d'ondes lumineuses d'intensité de l'ordre de 3000 mW/cm². Les deux courbes ont été enregistrées à une vitesse de balayage de 0,5 mV/s jusqu'à l'obtention d'une tension de 1,5 V (vs. Li⁺/Li). L'application d'une tension ou d'un courant dans les différentes expériences (i.e. circuit fermé) permet de décharger le dispositif par voie électrochimique. Nous rappelons toutefois que la décharge du dispositif se produit naturellement lorsque celui-ci est utilisé comme « batterie » pour alimenter un appareil électrique, c'est-à-dire sans application de tension ou de courant (i.e. circuit ouvert).

En absence d'ondes lumineuses, la courbe de décharge obtenue (ronds vides) est rigoureusement analogue à celle qui est obtenue pour une batterie non transparente au lithium classique constituée d'une électrode positive comprenant du TiO₂ (sans support conducteur transparent) et d'une électrode négative comprenant du lithium métal. Elle montre l'insertion de lithium dans le semi-conducteur de type n TiO₂ anatase induisant d'une part, la réduction partielle du métal de transition Ti⁴⁺ en Ti³⁺ et d'autre part, un changement de couleur de l'électrode passant de blanc (caractéristique du TiO₂) à un bleu intense. Ce changement de couleur résulte de la formation d'une nouvelle bande intermédiaire dans la structure de bande du matériau liée au caractère plus riche en électron de l'orbitale Ti³⁺ 3d-O 2p. L'insertion et la désinsertion du lithium dans ces conditions se déroule à un potentiel redox de l'ordre de 1,8 V (vs. Li⁺/Li) à l'équilibre. L'intégration de ladite courbe en fonction du temps permet de donner une valeur expérimentale de capacité gravimétrique de 69 mAh/g environ. Cette valeur est toutefois inférieure à la valeur théorique de 168 mAh/g, et qui correspond à une insertion d'environ 0,5 Li⁺ par unité formulaire. Cette différence de valeur s'explique d'une part, par l'absence dans l'électrode positive tel que préparée d'agent générant une conduction électronique tel que le carbone et d'autre part, par le régime d'insertion de lithium utilisé dans cet exemple qui est relativement élevé.

Toutefois, lorsque l'électrode positive (TiO₂) est soumise à une source d'ondes lumineuses d'intensité de l'ordre de 3000 mW/cm², l'insertion du lithium dans le semi-conducteur de type n TiO₂ anatase à l'état excité procède d'une manière tout à fait différente. La courbe de décharge obtenue (ronds pleins) montre le début de l'insertion du lithium vers 3 V, une première vague de réduction vers 2,4 V, puis une succession de phénomènes cathodiques jusqu'à 1,7 V et enfin un pic bien défini à 1,58 V. La densité de courant atteint des valeurs de l'ordre de 4,8 mA/cm² (à 1,58 V), alors que dans le noir (courbe avec les ronds vides) la densité de courant maximale est de 0,73 mA/cm² (à 1,5 V). La valeur de la capacité gravimétrique en présence d'une source lumineuse est alors de 619 mAh/g, cette valeur est nettement supérieure aux valeurs obtenues théoriquement et expérimentalement dans le noir. Une telle capacité en décharge correspondrait à environ deux lithium insérés par unité formulaire.

Durant le processus de décharge, l'électrode positive du dispositif conforme à l'invention subit une réaction inverse de photorecharge permettant une régénération continue de cette dernière. En d'autres termes, le potentiel appliqué induit une insertion de lithium et l'absorption de la lumière conduit à la réaction inverse d'extraction électrochimique du lithium permettant de photo-régénérer en partie ou en intégralité l'état initial de l'électrode selon les conditions de décharge.

La figure 3 annexée montre le potentiel par rapport au couple Li⁺/Li (en volts, V) en fonction de la capacité surfacique du dispositif électrochimique de l'invention (en µAh/cm²) dans le noir.

La figure 4 annexée montre le potentiel par rapport au couple Li⁺/Li (en volts, V) en fonction de la capacité surfacique du dispositif électrochimique de l'invention (en mAh/cm²) lorsque l'électrode positive (TiO₂) est soumise à une source d'ondes lumineuses d'intensité de l'ordre de 3000 mW/cm².

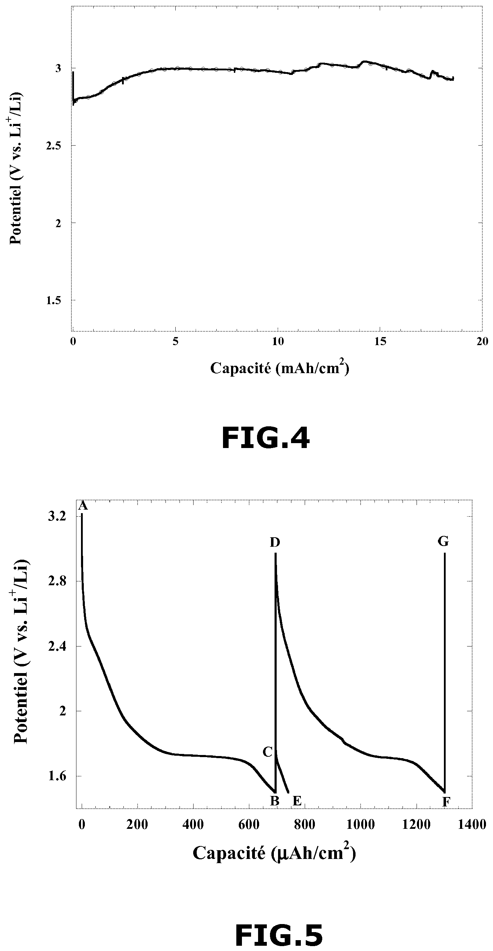

Les figures 3 et 4 ont été enregistrées en appliquant une densité de courant de -100 µA/cm² entre 1,5 V et 3 V (vs. Li⁺/Li).

L'insertion de lithium dans le noir (figure 3) conduit à une courbe de décharge/charge analogue à celle obtenue pour une batterie au lithium classique constituée d'une électrode positive comprenant du TiO₂ et d'une électrode négative comprenant du lithium métal, à l'exception d'une capacité irréversible plus élevée dans cet exemple qui s'explique par l'absence de carbone (agent générant une conductivité électronique) dans l'électrode positive telle que préparée ci-dessus. Lors de la première décharge, la capacité surfacique est d'environ 0,75 mAh/cm² à 1,5 V et elle est accompagnée d'un rapide changement de couleur de l'électrode passant du blanc au bleu.

Lorsque l'insertion du lithium est réalisée en présence d'une source d'ondes lumineuses (figure 4), dans les mêmes conditions expérimentales que celles-indiquées ci-dessus, une excellente capacité surfacique de 18,6 mAh/cm² est atteinte, ce qui correspond à une capacité gravimétrique de 10,4 Ah/g. En outre, le potentiel d'insertion obtenu est bien plus élevé que dans le noir puisqu'il est compris entre 2,8 et 3,05 V, ce qui correspond à une densité d'énergie de plus de 30 kWh/kg. Cette grande valeur est largement supérieure à toutes les valeurs obtenues avec les technologies de stockage électrochimique existantes actuellement.

Par ailleurs, au cours de la décharge, l'électrode est restée blanche ou faiblement bleutée à la fin de l'expérience.

Ces performances peuvent s'expliquer par la compétition entre l'insertion de lithium dans la structure imposée par la densité de courant appliquée de 100 µA/cm² d'électrode et le photocourant inverse généré par la séparation des charges prenant place dans la zone de déplétion qui conduit à la photorecharge concomittante de l'électrode par une réaction d'oxydation.

### 1.5 Photorecharge du dispositif conforme à l'invention en présence d'une source d'ondes lumineuses

La figure 5 annexée (courbe représentée par les points A, B, D, F et G) montre le potentiel par rapport au couple Li⁺/Li (en volts, V) en fonction de la capacité surfacique du dispositif électrochimique de l'invention (en µAh/cm²) lorsque ledit dispositif a été soumis aux étapes suivantes :
- une première décharge dans le noir en appliquant une densité de courant de 100 µA/cm², du potentiel de la cellule à circuit ouvert jusqu'à 1,5 V (vs. Li⁺/Li) (circuit fermé) (figure 5, courbe A-B),
- une exposition à une source d'ondes lumineuses d'intensité de l'ordre de 3 W/cm² pendant une heure (circuit ouvert) (figure 5, courbe B-D),
- une deuxième décharge dans le noir en appliquant une densité de courant de 100 µA/cm², du potentiel de la cellule à circuit ouvert jusqu'à 1,5 V (vs. Li⁺/Li) (circuit fermé) (figure 5, courbe D-F), et
- une exposition à une source d'ondes lumineuses d'intensité de l'ordre de 3000 mW/cm² pendant une heure (circuit ouvert) (figure 5, courbe F-G).

La figure 5 annexée (courbe représentée par les points A, B, C et E) montre le potentiel par rapport au couple Li⁺/Li (en volts, V) en fonction de la capacité surfacique du dispositif électrochimique de l'invention (en µAh/cm²) lorsque ledit dispositif a été soumis aux étapes suivantes :
- une première décharge dans le noir en appliquant une densité de courant de 100 µA/cm², du potentiel de la cellule à circuit ouvert jusqu'à 1,5 V (vs. Li⁺/Li) (circuit fermé) (figure 5, courbe A-B),
- une relaxation dans le noir pendant une heure (circuit ouvert) (figure 5, courbe B-C),
- une deuxième décharge dans le noir en appliquant une densité de courant de 100 µA/cm², du potentiel de la cellule à circuit ouvert jusqu'à 1,5 V (vs. Li⁺/Li) (circuit fermé) (figure 5, courbe C-E).

La figure 5 montre que le potentiel pour les deux courbes suivantes : la première courbe représentée par les points A, B, D, F et G et la deuxième courbe représentée par les points A, B, C et E est très différent. En effet, dans le noir le potentiel d'équilibre atteint est de 1,86 V (vs. Li⁺/Li) tandis qu'en présence d'ondes lumineuses, ce dernier est de 2,97 V (vs. Li⁺/Li). Par ailleurs, le dispositif qui a subi une période de relaxation dans le noir délivre une capacité faible qui correspond à la capacité restante au cours de la deuxième décharge, alors que le dispositif qui a subi une période d'exposition à une source d'ondes lumineuses délivre une capacité surfacique de 607 µAh/cm² quasi-équivalente à celle de 695 µAh/cm² obtenue au cours du premier cycle.

La figure 5 montre donc d'une part, que l'absorption de la lumière conduit à un phénomène de photorecharge et d'autre part, que ce phénomène est réversible « d'un point de vue électrochimique » (i.e. la capacité délivrée au deuxième cycle est quasi-équivalente à celle obtenue au premier cycle).

En outre, un changement de couleur du bleu intense au blanc (couleur caractéristique de TiO₂) de l'électrode positive pendant la période de relaxation d'une heure est observé. Ce changement de couleur de l'électrode positive témoigne de la réaction de photorecharge du dispositif.

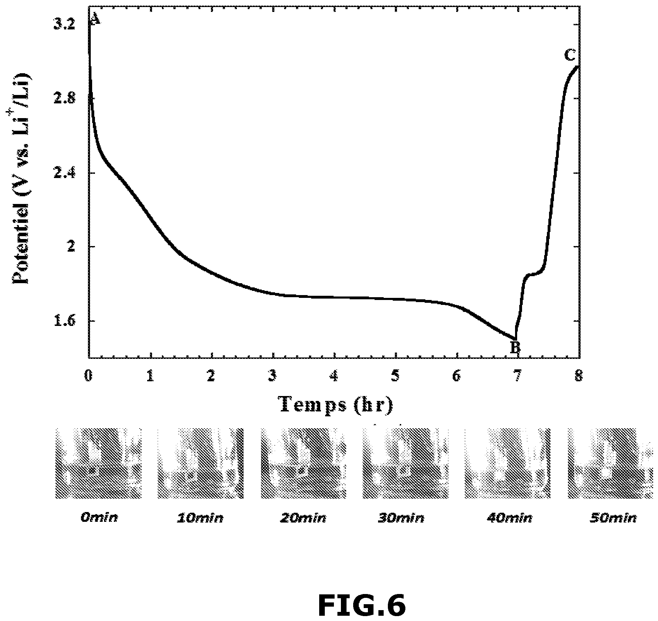

La figure 6 montre le potentiel par rapport au couple Li⁺/Li (en volts, V) en fonction du temps (en heures) lorsque le dispositif a été soumis aux étapes suivantes :
- une première décharge dans le noir en appliquant une densité de courant de 100 µA/cm², du potentiel de la cellule à circuit ouvert jusqu'à 1,5 V (vs. Li⁺/Li) (circuit fermé) (figure 6, courbe A-B),
- une exposition à une source d'ondes lumineuses d'intensité de l'ordre de 3000 mW/cm² pendant une heure (circuit ouvert) (figure 6, courbe B-C).

La figure 6 montre également l'évolution de la couleur de l'électrode positive au cours de l'illumination en fonction du temps (photographies à 0 min, 10 min, 20 min, 30 min, 40 min et 50 min).

D'après la figure 6, il peut être constaté que la photorecharge se produit en moins d'une heure.

### 1.6 Recharge du dispositif conforme à l'invention dans le noir

Le dispositif préalablement chargé conforme à l'invention a été soumis aux étapes suivantes :
- une exposition à une source d'ondes lumineuses d'intensité de l'ordre de 3000 mW/cm² pendant douze heures (circuit ouvert),
- une décharge dans le noir en appliquant une densité de courant de 100 µA/cm², du potentiel de la cellule à circuit ouvert jusqu'à 1,5 V (vs. Li⁺/Li) (circuit fermé),
- une période de relaxation dans le noir pendant 1 heure, 6 heures ou 12 heures (circuit ouvert).

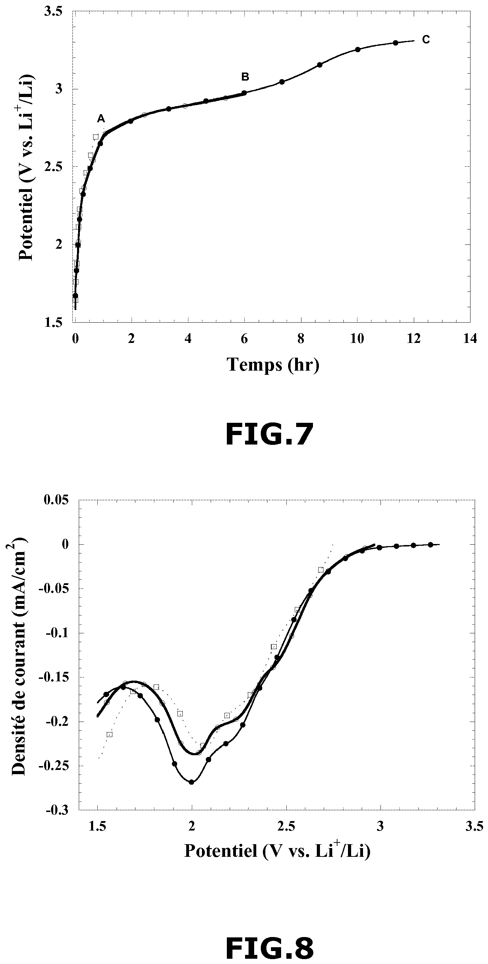

La figure 7 montre le potentiel par rapport au couple Li⁺/Li (en volts, V) en fonction du temps (en heures) pendant la période de relaxation dans le noir, lorsque celle-ci est de 1 heure (courbe avec les carrés vides), de 6 heures (courbe avec les ronds vides), et de 12 heures (courbe avec les ronds pleins).

La figure 8 montre la densité de courant (en mA/cm²) en fonction du potentiel par rapport au couple Li⁺/Li (en volts, V) pendant la période de relaxation dans le noir, lorsque celle-ci est de 1 heure (courbe avec les carrés vides), de 6 heures (courbe avec les ronds vides), et de 12 heures (courbe avec les ronds pleins).

La figure 8 montre que les densités de courant correspondent à des densités de courant enregistrées dans le noir et sont donc plus faibles d'un facteur 10 par rapport à celles-ci précédemment enregistrées en présence d'une source d'ondes lumineuses. Le profil électrochimique est différent de celui obtenu dans le noir et plus proche de celui obtenu en présence d'une source d'ondes lumineuses. L'intégration des trois courbes permet de calculer la capacité gravimétrique en décharge qui est comprise entre 46 et 51 mAh/g, comparable à celle obtenue dans le noir (cf. figure 2). L'évolution du potentiel à circuit ouvert est comparable à celui observé lors de l'exposition à une source d'ondes lumineuses (cf. figure 6), excepté que dans le cas présent le temps pour atteindre la valeur de 3 V est beaucoup plus important (12 heures). En effet, il a été montré précédemment qu'une photorecharge complète prenait seulement une heure.

Les résultats montrent donc qu'une à deux recharges sont encore possibles dans le noir même si la recharge prend un peu plus de temps. C'est une propriété unique qui est mise en évidence ici. Ceci devrait permettre au moins en partie de résoudre le problème inhérent de l'intermittence de l'énergie solaire ; le dispositif proposé pouvant se recharger au moins partiellement dans le noir. Le problème d'intermittence est également en partie résolu grâce à la bifonctionnalité de l'électrode positive photo-active qui peut délivrer en journée un courant continu en présence d'une source naturelle d'ondes lumineuses, et se décharger la nuit tout en délivrant une densité de courant de 100 µA/cm². A la fin de la nuit, l'électrode positive toujours en fonctionnement, se photo-régénère et peut soutenir de nombreux cycles jour/nuit tout en délivrant de l'énergie de manière constante.

## Revendications

1. Dispositif électrochimique photorechargeable transparent, ledit dispositif étant **caractérisé en ce qu'**il comprend :
- une électrode positive comprenant un support transparent conducteur sur lequel est déposé un film d'électrode positive, ledit film d'électrode positive comprenant un semi-conducteur de type n à titre de matière active d'électrode positive, ledit semiconducteur de type n présentant une largeur de bande interdite Eg et étant capable d'intercaler et de dés-intercaler des ions d'un métal alcalin M1 ;
- une électrode négative comprenant un élément choisi parmi ledit métal alcalin M1, un alliage dudit métal alcalin M1, et un composé intermétallique dudit métal alcalin M1 ;
- un électrolyte liquide non aqueux comprenant un sel dudit métal alcalin M1 et un solvant organique ; et
- lesdites électrodes positive et négative ayant respectivement des potentiels d'électrode E1 et E2, avec E1 > E2, E1 et E2 étant calculés par rapport au potentiel d'électrode du couple M1⁺/M1⁰.

2. Dispositif selon la revendication 1, **caractérisé en ce que** le métal alcalin M1 est choisi parmi le lithium, le sodium et le potassium.

3. Dispositif selon la revendication 1 ou 2, **caractérisé en ce que** le semi-conducteur de type n est choisi parmi les oxydes de métaux, les phosphates de métaux, les sulfates de métaux, et les oxalates de métaux, dans lesquels lesdits métaux sont choisis parmi Sc, Ti, V, Cr, Mn, Fe, Co, Ni, Cu, Zn, Y, Zr, Nb, Mo, Tc, Ru, Rh, Pd, Ag, Cd, Hf, Ta, W, Re, Os, Ir, Pt, Au, Hg, Rf, Db, Sg, Bh, Hs, Mt, Ds, Rg, Cn et Bi.

4. Dispositif selon la revendication 3, **caractérisé en ce que** les métaux sont choisis parmi Ti, Fe, Mn, Co, Ni, Sn, Ru, Bi, V, Cr, Cu, Nb, Mo et Zn.

5. Dispositif selon la revendication 3 ou 4, **caractérisé en ce que** les oxydes de métaux sont choisis parmi TiO₂, Fe₂O₃, Fe₃O₄, MnO₂, CoO, Co₃O₄, SnO₂, RuO₂, Bi₂O₃, VO₂, V₂O₅, Cr₂O₃, Nb₂O₅ et ZnO.

6. Dispositif selon l'une quelconque des revendications précédentes, **caractérisé en ce que** le semi-conducteur de type n est TiO₂.

7. Dispositif selon la revendication 3 ou 4, **caractérisé en ce que** les phosphates de métaux sont choisis parmi :
- les olivines répondant à la formule MM'PO₄,
- les dérivés fluorés, hydroxylés et oxygénés répondant aux formules MₓM"PO₄F, MₓM"PO₄.OH et MₓM"PO₄.O,
- les carbonophosphates répondant à la formule M₃M'PO₄CO₃, et
- les pyrophosphates répondant à la formule MₓM'P₂O₇,
dans lesquelles M = Li ou Na, M' = Fe, Co, Mn, Ni ou un de leurs mélanges, M" = Fe, Co, Mn, Ni, V ou Ti, et x va de 0 à 2.

8. Dispositif selon la revendication 3 ou 4, **caractérisé en ce que** les sulfates de métaux sont choisis parmi les matériaux répondant aux formules M'₂(SO₄)₃, MM"SO₄F et MₓM"OSO₄, dans lesquelles M = Li ou Na, M' = Fe, Co, Mn, Ni ou un de leurs mélanges, et M" = Fe, Co, Mn, Ni, V ou Ti.

9. Dispositif selon la revendication 3 ou 4, **caractérisé en ce que** les oxalates de métaux sont choisis parmi les composés répondant à la formule M₂M'(C₂O₄)₂, dans laquelle M = Li ou Na et M' = Fe, Co, Mn, Ni ou un de leurs mélanges.

10. Dispositif selon l'une quelconque des revendications précédentes, **caractérisé en ce que** le semi-conducteur de type n a une largeur de bande interdite Eg d'au plus 4,0 eV.

11. Dispositif selon l'une quelconque des revendications précédentes, **caractérisé en ce que** le semi-conducteur de type n comprend des particules de diamètre allant de 2 à 50 nm.

12. Dispositif selon l'une quelconque des revendications précédentes, **caractérisé en ce que** le semi-conducteur de type n a une surface spécifique mesurée par la méthode B.E.T. allant de 20 m²/g à 500 m²/g.

13. Dispositif selon l'une quelconque des revendications précédentes, **caractérisé en ce que** le film d'électrode positive a une structure poreuse comprenant au moins des mésopores.

14. Dispositif selon l'une quelconque des revendications précédentes, **caractérisé en ce que** le film d'électrode positive comprend en outre au moins un colorant et/ou au moins un réflecteur de lumière.

15. Dispositif selon l'une quelconque des revendications précédentes, **caractérisé en ce que** le support transparent conducteur est un verre transparent conducteur de type FTO, de type ITO, ou de type ZITO.

16. Dispositif selon l'une quelconque des revendications précédentes, **caractérisé en ce que** le film d'électrode positive présente une épaisseur allant de 0,1 à 25 µm.

17. Procédé de photorecharge d'un dispositif électrochimique photorechargeable transparent tel que défini à l'une quelconque des revendications 1 à 16, **caractérisé en ce qu'**il comprend l'étape suivante :
i) l'exposition dudit dispositif, de préférence du côté dudit dispositif comprenant ladite électrode positive, à une source d'ondes lumineuses pendant au moins 30 minutes, et de préférence pendant au moins 1 heure, pour obtenir ledit dispositif rechargé.

18. Procédé de recharge dans le noir d'un dispositif électrochimique photorechargeable transparent tel que défini à l'une quelconque des revendications 1 à 16, **caractérisé en ce qu'**il comprend les étapes suivantes :
i') l'exposition dudit dispositif, de préférence du côté dudit dispositif comprenant ladite électrode positive, à une source d'ondes lumineuses pendant au moins 10 heures,
ii') l'utilisation du dispositif de l'étape i') pour alimenter un appareil électrique, et
(iii') la relaxation dans le noir du dispositif de l'étape ii') pendant au moins 6 heures, pour obtenir ledit dispositif rechargé.

19. Utilisation d'un semi-conducteur de type n en tant que matière active d'électrode positive pour un dispositif électrochimique photorechargeable transparent tel que défini à l'une quelconque des revendications 1 à 16.

## Patentansprüche

1. Transparente, durch Licht wiederaufladbare, elektrochemische Vorrichtung, wobei die Vorrichtung **dadurch gekennzeichnet ist, dass** sie Folgendes umfasst:
- eine positive Elektrode, die einen transparenten, leitfähigen Träger umfasst, auf den ein Film einer positiven Elektrode abgeschieden wurde, wobei der Film der positiven Elektrode einen Halbleiter vom n-Typ als aktives Material der positiven Elektrode umfasst, wobei der n-Typ-Halbleiter eine Bandabstandsbreite Eg aufweist und fähig ist, Ionen eines Alkalimetalls M1 zu interkalieren und zu deinterkalieren;
- eine negative Elektrode, die ein Element umfasst, ausgewählt aus dem Alkalimetall M1, einer Legierung des Alkalimetalls M1 und einer intermetallischen Verbindung des Alkalimetalls M1;
- einen nichtwässrigen, flüssigen Elektrolyten, der ein Salz des Alkalimetalls M1 und ein organisches Lösungsmittel umfasst; und
- wobei die positive und negative Elektrode jeweils Elektrodenpotentiale E1 und E2 aufweisen, wobei E1 > E2 und wobei E1 und E2 bezogen auf das Elektronpotential des Paares M1⁺/M1⁰ berechnet sind.

2. Vorrichtung nach Anspruch 1, **dadurch gekennzeichnet, dass** das Alkalimetall M1 aus Lithium, Natrium und Kalium ausgewählt ist.

3. Vorrichtung nach Anspruch 1 oder 2, **dadurch gekennzeichnet, dass** der n-Typ-Halbleiter aus Metalloxiden, Metallphosphaten, Metallsulfaten und Metalloxalaten ausgewählt ist, wobei die Metalle aus Sc, Ti, V, Cr, Mn, Fe, Co, Ni, Cu, Zn, Y, Zr, Nb, Mo, Tc, Ru, Rh, Pd, Ag, Cd, Hf, Ta, W, Re, Os, Ir, Pt, Au, Hg, Rf, Db, Sg, Bh, Hs, Mt, Ds, Rg, Cn und Bi ausgewählt sind.

4. Vorrichtung nach Anspruch 3, **dadurch gekennzeichnet, dass** die Metalle aus Ti, Fe, Mn, Co, Ni, Sn, Ru, Bi, V, Cr, Cu, Nb, Mo und Zn ausgewählt sind.

5. Vorrichtung nach Anspruch 3 oder 4, **dadurch gekennzeichnet, dass** die Metalloxide aus TiO₂, Fe₂O₃, Fe₃O₄, MnO₂, CoO, CO₃O₄, SnO₂, RuO₂, Bi₂O₃, VO₂, V₂O₅, Cr₂O₃, Nb₂O₅ und ZnO ausgewählt sind.

6. Vorrichtung nach einem der vorhergehenden Ansprüche, **dadurch gekennzeichnet, dass** der n-Typ-Halbleiter TiO₂ ist.

7. Vorrichtung nach Anspruch 3 oder 4, **dadurch gekennzeichnet, dass** die Metallphosphate ausgewählt sind aus:
- Olivinen, die der Formel MM'PO₄ entsprechen,
- fluorierten, hydroxylierten und oxygenierten Derivaten, die den Formeln MₓM"PO₄F, MₓM"PO₄.OH und MₓM"PO₄.O entsprechen,
- Carbonophosphaten, die der Formel M₃M'PO₄CO₃ entsprechen, und
- Pyrophosphaten, die der Formel MₓM'P₂O₇ entsprechen,
in welchen M = Li oder Na, M' = Fe, Co, Mn, Ni oder eine ihrer Mischungen, M" = Fe, Co, Mn, Ni, V oder Ti und x von 0 bis 2 reicht.

8. Vorrichtung nach Anspruch 3 oder 4, **dadurch gekennzeichnet, dass** die Metallsulfate ausgewählt sind aus Materialien, die den Formeln M'₂(SO₄)₃, MM"SO₄F und MₓM"OSO₄ entsprechen, in denen M = Li oder Na, M' = Fe, Co, Mn, Ni oder eine ihrer Mischungen und M" = Fe, Co, Mn, Ni, V oder Ti.

9. Vorrichtung nach Anspruch 3 oder 4, **dadurch gekennzeichnet, dass** die Metalloxalate ausgewählt sind aus Verbindungen, die der Formel M₂M'(C₂O₄)₂ entsprechen, in denen M = Li oder Na und M' = Fe, Co, Mn, Ni oder eine ihrer Mischungen.

10. Vorrichtung nach einem der vorhergehenden Ansprüche, **dadurch gekennzeichnet, dass** der n-Typ-Halbleiter einen Bandabstand Eg von mindestens 4,0 eV aufweist.

11. Vorrichtung nach einem der vorhergehenden Ansprüche, **dadurch gekennzeichnet, dass** der n-Typ-Halbleiter Partikel mit einem Durchmesser zwischen 2 und 50 nm umfasst.

12. Vorrichtung nach einem der vorhergehenden Ansprüche, **dadurch gekennzeichnet, dass** der n-Typ-Halbleiter eine mittels dem BET-Verfahren gemessene spezifische Oberfläche von 20 m²/g bis 500 m²/g aufweist.

13. Vorrichtung nach einem der vorhergehenden Ansprüche, **dadurch gekennzeichnet, dass** der Film der positiven Elektrode eine poröse Struktur aufweist, die mindestens Mesoporen umfasst.

14. Vorrichtung nach einem der vorhergehenden Ansprüche, **dadurch gekennzeichnet, dass** der Film der positiven Elektrode des Weiteren mindestens einen Farbstoff und/oder mindestens einen Lichtreflektor umfasst.

15. Vorrichtung nach einem der vorhergehenden Ansprüche, **dadurch gekennzeichnet, dass** der transparente, leitfähige Träger ein transparentes, leitfähiges Glas vom Typ FTO, vom Typ ITO oder vom Typ ZITO ist.

16. Vorrichtung nach einem der vorhergehenden Ansprüche, **dadurch gekennzeichnet, dass** der Film der positiven Elektrode eine Dicke von 0,1 bis 25 µm aufweist.

17. Verfahren zum Wiederaufladen mit Licht einer transparenten, mit Licht wiederaufladbaren, elektrochemischen Vorrichtung nach einem der Ansprüche 1 bis 16, **dadurch gekennzeichnet, dass** es den folgenden Schritt umfasst:
i) Exposition der Vorrichtung, vorzugsweise von der Seite der Vorrichtung, welche die positive Elektrode umfasst, gegenüber einer Lichtwellenquelle über mindestens 30 Minuten und vorzugsweise über mindestens 1 Stunde, um die wieder aufgeladene Vorrichtung zu erhalten.

18. Verfahren zum Wiederaufladen einer transparenten, mit Licht wiederaufladbaren, elektrochemischen Vorrichtung nach einem der Ansprüche 1 bis 16 im Dunkeln, **dadurch gekennzeichnet, dass** es die folgenden Schritte umfasst:
i') Exposition der Vorrichtung, vorzugsweise von der Seite der Vorrichtung, welche die positive Elektrode umfasst, gegenüber einer Lichtwellenquelle über mindestens 10 Stunden,
ii') Nutzung der Vorrichtung von Schritt i'), um ein elektrisches Gerät mit Strom zu versorgen, und
(iii') Relaxation der Vorrichtung von Schritt ii') im Dunkeln über mindestens 6 Stunden, um die wieder aufgeladene Vorrichtung zu erhalten.

19. Nutzung eines Halbleiters vom n-Typ als aktives Material der positiven Elektrode für eine transparente, mit Licht wiederaufladbare, elektrochemische Vorrichtung nach einem der Ansprüche 1 bis 16.

## Claims

1. Transparent photorechargeable electrochemical device, said device being **characterized in that** it comprises:
- a positive electrode comprising a transparent conductive support on which a positive electrode film is laid, said positive electrode film comprising an n-type semiconductor as positive electrode active material, said n-type semiconductor having a band gap Eg and being able to insert and remove ions of an alkaline metal M1;
- a negative electrode comprising an element selected from said alkaline metal M1, an alloy of said alkaline metal M1, and an intermetallic compound of said alkaline metal M1;
- a non-aqueous liquid electrolyte comprising a salt of said alkaline metal M1 and an organic solvent; and
- said positive and negative electrodes having electrode potentials E1 and E2, respectively, where E1 > E2, E1 and E2 being calculated with respect to the coupling electrode potential M1⁺/M1⁰.

2. Device according to claim 1, **characterized in that** the alkaline metal M1 is selected from lithium, sodium and potassium.

3. Device according to either claim 1 or claim 2, **characterized in that** the n-type semiconductor is selected from the metal oxides, the metal phosphates, the metal sulfates and the metal oxalates, said metals being selected from Sc, Ti, V, Cr, Mn, Fe, Co, Ni, Cu, Zn, Y, Zr, Nb, Mo, Tc, Ru, Rh, Pd, Ag, Cd, Hf, Ta, W, Re, Os, Ir, Pt, Au, Hg, Rf, Db, Sg, Bh, Hs, Mt, Ds, Rg, Cn and Bi.

4. Device according to claim 3, **characterized in that** the metals are selected from Ti, Fe, Mn, Co, Ni, Sn, Ru, Bi, V, Cr, Cu, Nb, Mo and Zn.

5. Device according to either claim 3 or claim 4, **characterized in that** the metal oxides are selected from TiO₂, Fe₂O₃, Fe₃O₄, MnO₂, CoO, Co₃O₄, SnO₂, RuO₂, Bi₂O₃, VO₂, V₂O₅, Cr₂O₃, Nb₂O₅ and ZnO.

6. Device according to any of the preceding claims, **characterized in that** the n-type semiconductor is TiO₂.

7. Device according to either claim 3 or claim 4, **characterized in that** the metal phosphates are selected from:
- the olivines of formula MM'PO₄,
- the fluorinated, hydroxylated and oxygenated derivatives of formulae MₓM"PO₄F, MₓM"PO₄.OH and MₓM"PO₄.O,
- the carbonophosphates of formula M₃M'PO₄CO₃, and
- the pyrophosphates of formula MₓM'P₂O₇,
in which M = Li or Na, M' = Fe, Co, Mn, Ni or one of the mixtures thereof, M" = Fe, Co, Mn, Ni, V or Ti, and x is between 0 and 2.

8. Device according to either claim 3 or claim 4, **characterized in that** the metal sulfates are selected from the materials of formulae M'₂(SO₄)₃, MM"SO₄F and MₓM"OSO₄, in which M = Li or Na, M' = Fe, Co, Mn, Ni or one of the mixtures thereof, and M" = Fe, Co, Mn, Ni, V or Ti.

9. Device according to either claim 3 or claim 4, **characterized in that** the metal oxalates are selected from the compounds of formula M₂M'(C₂O₄)₂, in which M = Li or Na, and M' = Fe, Co, Mn, Ni or one of the mixtures thereof.

10. Device according to any of the preceding claims, **characterized in that** the n-type semiconductor has a band gap Eg of at most 4.0 eV.

11. Device according to any of the preceding claims, **characterized in that** the n-type semiconductor comprises particles of a diameter of from 2 to 50 nm.

12. Device according to any of the preceding claims, **characterized in that** the n-type semiconductor has a specific surface area, measured by means of the BET method, of from 20 m²/g to 500 m²/g.

13. Device according to any of the preceding claims, **characterized in that** the positive electrode film has a porous structure comprising at least mesopores.

14. Device according to any of the preceding claims, **characterized in that** the positive electrode film further comprises at least one colorant and/or at least one light reflector.

15. Device according to any of the preceding claims, **characterized in that** the transparent conductive support is a transparent conductive glass of the FTO type, of the ITO type or of the ZITO type.

16. Device according to any of the preceding claims, **characterized in that** the positive electrode film has a thickness of from 0.1 to 25 µm.

17. Method for photorecharging a transparent photorechargeable electrochemical device as defined in any of claims 1 to 16, **characterized in that** said method comprises the step of:
i) exposing said device, preferably on the side of said device that comprises said positive electrode, to a source of light waves for at least 30 minutes, and preferably for at least 1 hour, in order to obtain said recharged device.

18. Method for recharging a transparent photorechargeable electrochemical device as defined in any of claims 1 to 16, in the dark, **characterized in that** said method comprises the steps of:
i') exposing said device, preferably on the side of said device that comprises said positive electrode, to a source of light waves for at least 10 hours,
ii') using the device of step i') to supply an electrical apparatus, and
(iii') relaxing the device of step ii') in the dark for at least 6 hours in order to obtain said recharged device.

19. Use of an n-type semiconductor as positive electrode active material for a transparent photorechargeable electrochemical device as defined in any of claims 1 to 16.
